Europäisches Patentamt

European Patent Office

Office européen des brevets

(11) Publication number: **0 326 187**
**A2**

## (12) EUROPEAN PATENT APPLICATION

(21) Application number: **89104187.3**

(22) Date of filing: **17.05.83**

(51) Int. Cl.4: **H01L 29/78** , **H01L 29/10** , **H01L 29/52**

(30) Priority: **20.05.82 US 380170**

(43) Date of publication of application:
**02.08.89 Bulletin 89/31**

(60) Publication number of the earlier application in accordance with Art.76 EPC: **0 094 891**

(84) Designated Contracting States:
**DE FR GB IT NL**

(71) Applicant: **FAIRCHILD SEMICONDUCTOR CORPORATION**
**2900 Semiconductor Drive**
**Santa Clara California 95051-8090(US)**

(72) Inventor: **Vora, Madhukar B.**
**110 Lansberry Court**
**Los Gatos, CA 95030(US)**
Inventor: **Patel, Vikram M.**
**19444 DeHavilland Drive**
**Saratoga, CA 95070(US)**

(74) Representative: **Dipl.-Ing. K. Sparing**
**Dipl.-Phys.Dr. W.H. Röhl Dipl.-Min.Dr. D. Henseler Patentanwälte**
**Rethelstrasse 123 Postfach 14 02 68**
**D-4000 Düsseldorf(DE)**

(54) Power MOSFET structure.

(57) A Power MOSFET semiconductor structure is fabricated using the steps of depositing an epitaxial layer of N conductivity type silicon on an underlying silicon substrate of N conductivity type, forming a plurality of polycrystalline silicon electrodes on the epitaxial layer, each electrode being separated from the epitaxial layer by a layer of insulating material; introducing P and N conductivity type impurities into the epitaxial layer between the electrodes, the P type impurity underlying the N type impurity; removing regions of the epitaxial layer to form openings in the epitaxial layer between the electrodes, the removed regions extending through the N type region but not through the P type region; and depositing electrically conductive material in the opening.

The resulting semiconductor structure includes an N type substrate, an N type epitaxial layer, an opening in the epitaxial layer extending downward a selected distance, an upper N type region surrounding the opening and extending to the surface of the epitaxial layer, a lower P type region which extends to the surface of the epitaxial layer and everywhere separates the N type region from the epitaxial layer, an electrode formed in the opening and extending to the upper surfce of the epitaxial layer, and a second electrode disposed above the epitaxial layer and separated from it by insulating material.

FIG. I

## POWER MOSFET STRUCTURE

### Background of the Invention

#### Field of the Invention

This invention relates to integrated circuit structures and in particular to an improved power metal oxide semiconductor field effect transistor (MOSFET) structure having higher switching speeds and improved breakdown characteristics.

#### Description of the Prior Art

Continuing improvements in integrated circuit fabrication technology have lead to the manufacture of MOSFET's which are capable of efficient high frequency switching of relatively large amounts of power. The power MOSFET represents one of the first power semiconductor devices manufacturable using integrated circuit processing technology. A survey article discussing power MOSFET's is entitled "Switching Lots of Watts at High Speed" by B. Baliga, IEEE Spectrum, December 1981, pages 42-48.

One promising technology for the manufacture of advanced power MOSFET structures is VDMOS, meaning MOS devices fabricated using double diffusions in V-shaped grooves. Unfortunately conventionally fabricated VDMOS structures suffer from several disadvantages. Such devices are generally overly susceptible to secondary breakdown of parasitic bipolar transistors inherent in the structure. Furthermore, such structures typically have undesirably large drain to source resistance when on. In addition, the devices switch at undesirably low speeds in view of their relatively large size and therefore high gate capacitances.

### Summary of the Invention

This invention provides a power MOSFET having improved performance characteristics over those of the prior art. In particular, this invention provides a power MOSFET structure which is less susceptible to secondary breakdown of parasitic transistors inherent in the integrated circuit structure, which has a lower drain to source resistance, which is capable of switching at higher speeds with lower gate capacitance than prior art devices.

In one embodiment a semiconductor structure fabricated according to this invention includes a semiconductor drain region of first conductivity type having an upper surface; an opening in the drain region extending downward from the upper surface a selected distance; a source region of first conductivity type contiguous to the opening and to the upper surface; a gate region of opposite conductivity type everywhere disposed between the source region and the drain region and extending to the surface of the drain region; a gate electrode disposed above all of the gate region and separated therefrom by insulating material, and means for providing electrical connections to the source region, the drain region, and the gate electrode.

In one embodiment a method for fabricating the power MOSFET structure comprises the steps of forming an electrically conductive gate electrode on a semiconductor drain region of first conductivity type, the electrode being separated from the drain region by a layer of insulating material; introducing first and opposite conductivity type impurities into the drain region adjacent the electrode to thereby form source and gate regions, respectively, the opposite conductivity type underlying the first conductivity type; removing portions of the drain region to form openings adjacent the electrodes, the removed portions extending through the first conductivity type but not through the opposite conductivity type; and providing electrical connections to the drain region, the source region and the gate electrode.

### Brief Description of the Drawings

Figures 1 through 6 illustrate a method for fabricating a power MOSFET structure where:

Figure 1 is a cross-sectional view of a semiconductor structure which may be manufactured using known techniques.

Figure 2 is a subsequent cross-sectional view after etching the structure shown in Figure 1.

Figure 3 is subsequent cross-sectional view after formation of additional insulating material.

Figure 4 is subsequent cross-sectional view after introduction of P conductivity type impurity.

Figure 5 is a subsequent cross-sectional view after further etching of the structure, and introduction of additional P type impurity.

Figure 6 is a cross-sectional view of the completed structure.

Figure 7 is an electrical schematic of the structure shown in Figure 6.

Detailed Description of the Preferred Embodiments

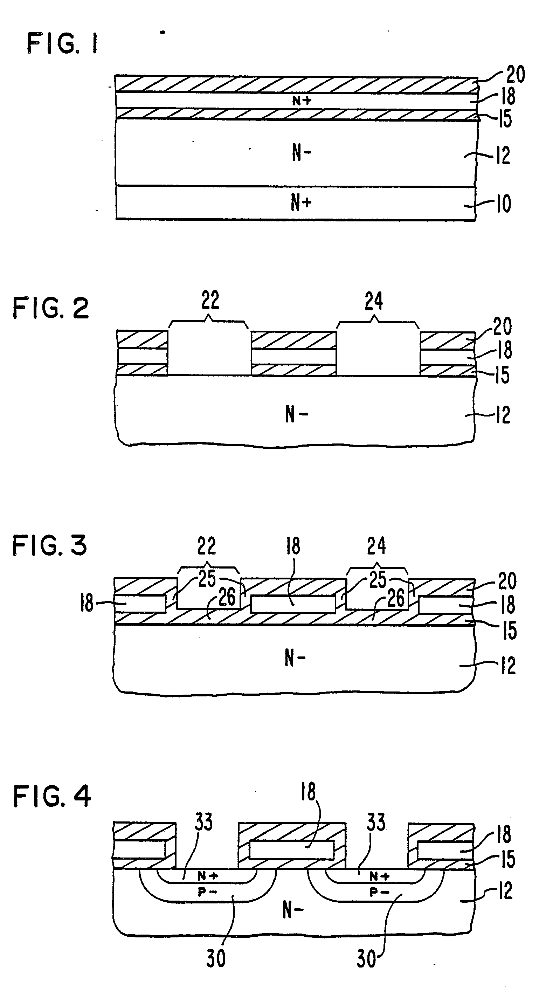

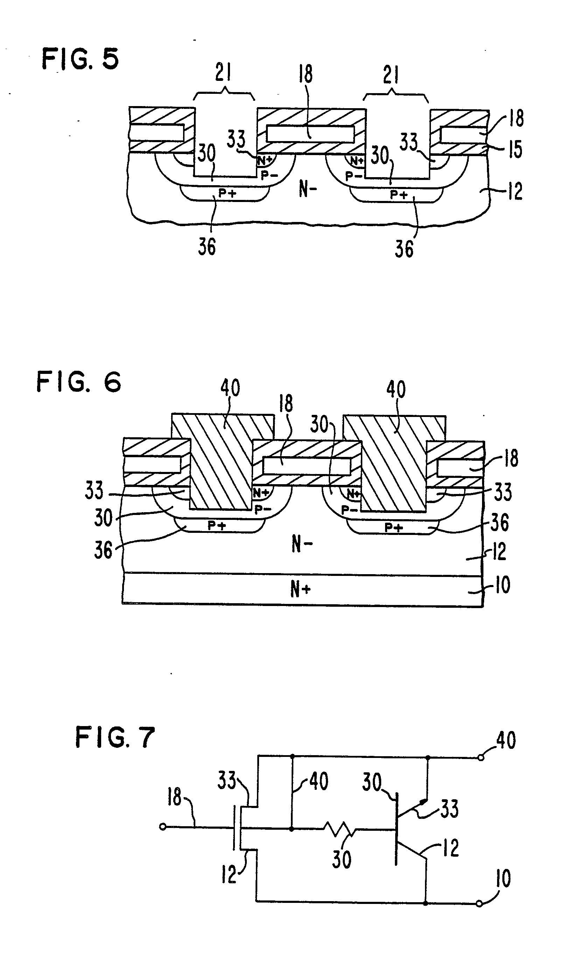

A cross-sectional view of the preferred embodiment of the semiconductor structure of this invention is shown in Figure 6. Figures 1 through 6 illustrate a method by which this power MOSFET structure may be manufactured. Figure 1 is a cross-sectional view of a semiconductor structure which may be fabricated using known processes. As shown in Figure 1, a lightly doped N- conductivity type epitaxial silicon layer 12 is deposited on the upper surface of a heavily doped N+ conductivity type silicon substrate 10. In the preferred embodiment substrate 10 is a commercially available silicon substrate doped with antimony to an impurity concentration of $10^{19}$ atoms per cubic centimeter. Epitaxial layer 12 may be formed across the upper surface of substrate 10 using a suitable epitaxial reactor. In the preferred embodiment epitaxial layer 12 is 10-50 microns thick and has a phosphorous impurity concentration of $10^{14}$ atoms per cubic centimeter. Substrate 10 will function as an electrical contact to epitaxial silicon 12 which will become the drain of the MOSFET. On the upper surface of epitaxial layer 12 a relatively thin layer of silicon dioxide 15 is formed. In the preferred embodiment silicon dioxide 15 is 2000 Angstroms thick and is formed by heating the underlying structure to a temperature of 1000°C for 2 hours in oxygen. Silicon dioxide 15 will become the gate oxide of the MOSFET.

On the upper surface of silicon dioxide 15 a layer of polycrystalline silicon 18 is deposited, for example, using chemical vapor deposition. Polycrystalline silicon 18 will typically be on the order of 8000 Angstroms thick and is doped with arsenic to an impurity concentration of $10^{20}$ atoms per cubic centimeter. Polycrystalline silicon 18 may be doped while it is being deposited, or impurities may be introduced into it after deposition using known diffusion or ion implantation processes. Regions of the conductive polysilicon 18 will become the gate electrodes. Finally, as shown in Figure 1, on the upper surface of polycrystalline silicon 18 a second layer of silicon dioxide 20 is formed, for example, by heating the underlying structure to a temperature of 1000°C for 30 minutes to create a layer 5000 Angstroms thick.

Using well-known integrated circuit fabrication technology, a suitable mask (not shown) is deposited and patterned on the upper surface of silicon dioxide 20. The underlying layers of silicon dioxide 15 and 20 and polycrystalline silicon 18 are then removed from regions 22 and 24 as shown by Figure 2. In the preferred embodiment this etching step is performed using plasma or reactive ion etching to thereby create relatively vertical cuts through the "sandwich" structure formed by layers 15, 18 and 20. Suitable etch gases for removing the silicon dioxide layers 15 and 20 include carbon tetrafluoride, while polycrystalline silicon 18 may be removed using carbon tetrachloride. As will be evident, the polycrystalline silicon 18 will be allowed to remain on the structure wherever gate electrodes for the power MOSFET structure are desired.

The structure shown in Figure 2 is then oxidized by heating it to a temperature of 800°C for 2 hours to create the silicon dioxide 25 and 26 shown in regions 22 and 24 of Figure 3. The silicon dioxide forming on the side walls of the structure depicted will be approximately 3000 Angstroms thick, while that which forms directly on the surface of epitaxial silicon 12 will be approximately 8000 Angstroms thick. The silicon dioxide 25 on the side walls will serve to electrically isolate electrodes formed in regions 22 and 24 from the doped polycrystalline silicon gate electrodes 18. In addition, silicon dioxide 25 functions as a mask for the following etching step. The structure shown in Figure 3 is then etched to remove the silicon dioxide 26 from the bottom of the central portion of regions 22 and 24 as shown by Figure 4. This step may be accomplished using well-known plasma etching apparatus and carbon tetrafluoride etch gas.

Next, as also shown in Figure 4, P and N conductivity type dopants are introduced into the upper surface of epitaxial layer 12 through the surfaces from which silicon dioxide 26 has been removed. These dopants form a P conductivity type region 30 and an N conductivity type region 33 in each opening. The dopants may be introduced using a variety of process operations. For example, in one embodiment the P conductivity type regions 30 are formed by ion implanting them below the surface of epitaxial layer 12. Then, using a lower implant energy, the N conductivity type regions 33 are fabricated closer to the upper surface of epitaxial material 12. The structure is then heated to a temperature of 1000°C for 2 hours to allow the implanted regions to diffuse into the configuration shown in Figure 4. Alternatively, a well-known double diffusion process may be performed to introduce these impurities. In the preferred embodiment the P type regions 30 will have a surface impurity concentration of $10^{17}$ boron atoms per cubic centi meter, while the N conductivity type regions 33 will have a surface impurity concentration of $10^{20}$ arsenic atoms per cubic centimeter.

Following the introduction and diffusion of these impurities any silicon dioxide formed on the surface of epitaxial material 12 is removed, and the silicon itself etched in the manner shown in Figure 5. In the preferred embodiment epitaxial silicon 12 will be etched using a plasma or reative ion process to create an opening which has substantially vertical sides, is 4000 Angstroms deep and extends at least all the way through N conductivity type regions 33. In embodiments in which epitaxial material 12 is N type monocrystalline silicon, a well-known preferential chemical etch may be performed to create a V-groove structure.

After fabrication of openings 21 in epitaxial material 12, boron or other P conductivity type impurity may be implanted into the bottom of the openings 21 to form regions 36. Typically these regions will be doped to a concentration of $10^{20}$ atoms per cubic centimeter. If necessary the structure may then be heated to diffuse of the P type impurities 36 to form the structure shown in Figure 5.

Next, as shown in Figure 6, metal connections 40 are formed. These connections are typically formed by depositing a layer of aluminum across the entire upper surface of the structure and into openings 21. Using well-known masking and photolithographic techniques the metal layer is patterned into desired regions 40. Electrodes 40 function as contacts to the N conductivity type source regions and "short" source region 33 to gate region 30. The strongly doped N conductivity type wafer 10 is again shown in Figure 6 to illustrate the manner in which any electrical connection to the drain 12 of the power MOSFET is made. In a typical embodiment all of the gate electrodes 18 will be electrically connected to each other, as will all source electrodes 40. In this manner, a single chip will be cap able of controlling substantially more power than any single MOSFET therein.

Figure 7 is a schematic diagram of an equivalent discrete circuit to the integrated circuit structure shown in Figure 6. As shown by Figure 7 the power MOS device is formed by gate 30, source 33, drain 12, and gate electrode 18. Metal contact 40 provides an electrical connection to source 33, while region 10 provides a connection to drain 12. The parasitic bipolar transistor formed by the structure shown in Figure 6 includes collector 12, emitter 33, and base 30.

The strongly doped P type regions 36 beneath the gate and parasitic base region 30 reduce the base resistance of the parasitic bipolar transistor. Because the breakdown voltage of the MOS device is usually limited by the collector-emitter breakdown voltage of the parasitic bipolar device, (which in turn is proportional to the product of the collector-base breakdown voltage and the base resistance), the lowered base resistance increases the overall power MOS device breakdown voltage. The breakdown voltage may be further increased by improving the transconductance of the structure by increasing the packing density of the MOS devices formed on a single chip. The lowered gate capacitance per unit cell resulting from self-alignment of the gate and source, provides an increased ratio of transconductance to gate capacitance, thereby improving switching speed.

Advantages of the structure depicted in Figure 6 include a significant reduction in the base resistance of the parasitic bipolar NPN transistor. This results from the self-aligned edge of the N+ diffusion 33 with the edge of the overlying polycrystalline silicon gate 18. The self-alignment increases the collector-emitter breakdown voltage of the parasitic bipolar transistor. Furthermore, by virtue of its compact layout, the structure shown in Figure 6 provides reduced source-drain resistance and increased transconductance over prior art structures.

Although one embodiment of the process and structure of this invention has been described above, this embodiment is intended only to illustrate the invention. Other uses of the structure will be apparent. For example by biasing the structure in an opposite manner, the source will become the drain, and the drain will become the source. The scope of the invention may be ascertained from the appended claims.

**Claims**

1. A semiconductor structure comprising:
a semiconductor drain region of first conductivity type having an upper surface;
an opening in the drain region extending downward from the upper surface a selected distance;
a source region of first conductivity type contiguous to the opening and to the upper surface;
a gate region of opposite conductivity type everywhere disposed between the source region and the drain region, and extending to the surface of the drain region;
a gate electrode disposed above all of the gate region and separated therefrom by insulating material; and
means for providing electrical connections to the source region, and the drain region, and the gate electrode.

2. A structure as in claim 1 wherein the means for providing comprises an electrode deposited in the opening.

3. A structure as in claim 1 wherein the drain region comprises an epitaxial layer of semiconductor material.

4. A structure as in claim 2 wherein the means for providing comprises a semiconductor substrate upon which the epitaxial layer is formed.

5. A structure as in claim 1 wherein the opening includes substantially vertical side walls.

6. A structure as in claim 1 wherein the gate electrode comprises polycrystalline silicon.

7. A structure as in claim 5 wherein the insulating material comprises silicon dioxide.

FIG. 1

FIG. 2

FIG. 3

FIG. 4

# FIG. 5

21  18  21

18
15
30  33  N+  N+  30  33
P-  P-
P+  N-  P+  12
36  36

# FIG. 6

40  18  30  40

18
33  N+  N+  33
30  P-  P-  36
36  P+  P+  12
N-
N+  10

# FIG. 7

40

18  33  40  30
33
12  30  12

10